# EUROPEAN PATENT APPLICATION

(11) **EP 4 475 635 A1**
(43) Date of publication of application: **11.12.2024**
(21) Application number: 23767152.4
(22) Date of filing: 08.03.2023
(51) Int. Cl.: H05K 1/14, H05K 9/00, H05K 1/18, H01Q 1/38, H01Q 1/24, H04M 1/02

(54) **ELECTRONIC DEVICE COMPRISING BRIDGE PRINTED CIRCUIT BOARD**

(30) Priority: 08.03.2022 KR 20220029427; 06.05.2022 KR 20220055982
(71) Applicant: Samsung Electronics Co., Ltd., Gyeonggi-do, 16677 (KR)
(72) Inventor: MIN, Bongkyu, Suwon-si Gyeonggi-do 16677 (KR); KIM, Taewoo, Suwon-si Gyeonggi-do 16677 (KR); PARK, Jinyong, Suwon-si Gyeonggi-do 16677 (KR); YUN, Hyelim, Suwon-si Gyeonggi-do 16677 (KR); LEE, Hyeongju, Suwon-si Gyeonggi-do 16677 (KR)
(74) Representative: HGF
(86) International application number: PCT/KR2023/003141
(87) International publication number: WO 2023/172051

(57) **Abstract**

According to various embodiments, an electronic device may comprise: a first printed circuit board including a main hole; a second printed circuit board inserted into the main hole and encompassed by the first printed circuit board; a bridge printed circuit board, which connects the first printed circuit board and the second printed circuit board, is overlapped with each of the first printed circuit board and the second printed circuit board and includes a bridge hole; an application processor disposed on the second printed circuit board, inserted into the bridge hole and encompassed by the bridge printed circuit board; and a main shield, which is connected to the bridge printed circuit board and covers the application processor. Other various embodiments are possible.

## Description

### BACKGROUND

### 1. Field

The disclosure relates to an electronic device including a bridge printed circuit board (PCB).

### 2. Description of Related Art

A printed circuit board (PCB) structure may be a structure in which a plurality of PCBs is connected to each other. At least one electronic component may be disposed on each PCB. As the plurality of PCBs is connected to each other, the height of the PCB structure may increase.

### SUMMARY

Various electronic components may be disposed on a printed circuit board (PCB). For example, at least one of an application processor (AP), a power management integrated circuit (PMIC), a decapsulator, and a plurality of integrated circuits (ICs) may be disposed on a PCB. The IC may be an electronic component in which a plurality of active elements and passive elements is integrated in micro. For example, the active element may include a transistor or a tube and the passive element may include a resistor or a condenser.

The specification of a PCB may be determined depending on various factors. For example, the PCB may be divided into a high-specification PCB having relatively high specifications and a low-specification PCB having relatively low specifications. For example, an AP, a PMIC, and/or a decapsulator may be disposed on the high-specification PCB, and a plurality of ICs may be disposed on the low-specification PCB. For example, on the high-specification PCB, more metal layers may be disposed compared to the low-specification PCB, and a low-loss dielectric may be included between the metal layers. Some of the PCBs may be provided as high-specification PCBs and the others may be provided as low-specification PCBs. Through the arrangement described above, the manufacturing cost of the PCB structure may be reduced.

A method of implementing a slim-structured PCB structure has been developed by decreasing the height of the PCB structure while connecting a plurality of PCBs to each other.

Various embodiments may provide an electronic device that implements a slim structure through a bridge PCB.

In accordance with an aspect of the disclosure, an electronic device is provided. The electronic device includes a first PCB including a main hole, a second PCB inserted into the main hole and enclosed by the first PCB, a bridge PCB configured to connect the first PCB and the second PCB and disposed so as to overlap the first PCB and the second PCB, the bridge PCB including a bridge hole, an application processor disposed on the second PCB, inserted into the bridge hole, and enclosed by the bridge PCB, and a main shield connected to the bridge PCB and configured to cover the application processor.

In accordance with another aspect of the disclosure, an electronic device is provided. The electronic device includes a first PCB including a main hole, a second PCB inserted into the main hole and enclosed by the first PCB, and a bridge PCB configured to connect the first PCB and the second PCB and disposed so as to overlap the first PCB and the second PCB, wherein the bridge PCB includes a bridge hole.

In accordance with another aspect of the disclosure, the electronic device is provided. The electronic device includes a first PCB including a main hole, a second PCB inserted into the main hole and enclosed by the first PCB, a bridge PCB configured to connect the first PCB and the second PCB and disposed so as to overlap the first PCB and the second PCB, the bridge PCB including a bridge hole, an application processor disposed on the second PCB, inserted into the bridge hole, and enclosed by the bridge PCB, a main shield connected to the bridge PCB and configured to cover the application processor, and a first component disposed on the first PCB and spaced apart from the bridge PCB in a direction intersecting with a stacking direction of the first PCB and the bridge PCB, wherein a maximum distance from one surface of the first PCB to one surface of the main shield is greater than a height of the IC, and the main hole and the bridge hole are provided in parallel with each other in a stacking direction of the first PCB and the bridge PCB.

According to various embodiments, an electronic device implements a slim structure by causing a first PCB and a second PCB to be provided in parallel with each other by connecting the first PCB to the second PCB through a bridge PCB.

Other aspects, advantages, and salient features of the disclosure will become apparent to those skilled in the art from the following detailed description, which, taken in conjunction with the annexed drawings, discloses various embodiments of the disclosure.

### BRIEF DESCRIPTION OF THE DRAWINGS

FIG. 1 is a block diagram illustrating an electronic device in a network environment according to an embodiment of the disclosure;
FIG. 2 is a plan view of an electronic device according to an embodiment of the disclosure;
FIG. 3A is a cross-sectional view of an electronic device according to an embodiment of the disclosure;
FIG. 3B is a perspective view of an electronic device according to an embodiment of the disclosure;
FIG. 4 is a cross-sectional view of an electronic device according to an embodiment of the disclosure;
FIG. 5 is a cross-sectional view of an electronic device according to an embodiment of the disclosure;
FIG. 6A is a cross-sectional view of an electronic device according to an embodiment of the disclosure;
FIG. 6B is a perspective view of an electronic device according to an embodiment of the disclosure; and
FIG. 7 is a perspective view of an electronic device according to an embodiment of the disclosure.

The same reference numerals are used to represent the same elements throughout the drawings.

### DETAILED DESCRIPTION

The following description with reference to the accompanying drawings is provided to assist in a comprehensive understanding of various embodiments of the disclosure as defined by the claims and their equivalents. It includes various specific details to assist in that understanding but these are to be regarded as merely exemplary. Accordingly, those of ordinary skill in the art will recognize that various changes and modifications of the various embodiments described herein can be made without departing from the scope and spirit of the disclosure. In addition, descriptions of well-known functions and constructions may be omitted for clarity and conciseness.

The terms and words used in the following description and claims are not limited to the bibliographical meanings, but, are merely used by the inventor to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

It should be appreciated that the blocks in each flowchart and combinations of the flowcharts may be performed by one or more computer programs which include instructions. The entirety of the one or more computer programs may be stored in a single memory device or the one or more computer programs may be divided with different portions stored in different multiple memory devices.

Any of the functions or operations described herein can be processed by one processor or a combination of processors. The one processor or the combination of processors is circuitry performing processing and includes circuitry like an application processor (AP, e.g. a central processing unit (CPU)), a communication processor (CP, e.g., a modem), a graphics processing unit (GPU), a neural processing unit (NPU) (e.g., an artificial intelligence (AI) chip), a Wi-Fi chip, a Bluetooth^{®} chip, a global positioning system (GPS) chip, a near field communication (NFC) chip, connectivity chips, a sensor controller, a touch controller, a finger-print sensor controller, a display drive integrated circuit (IC), an audio CODEC chip, a universal serial bus (USB) controller, a camera controller, an image processing IC, a microprocessor unit (MPU), a system on chip (SoC), an IC, or the like.

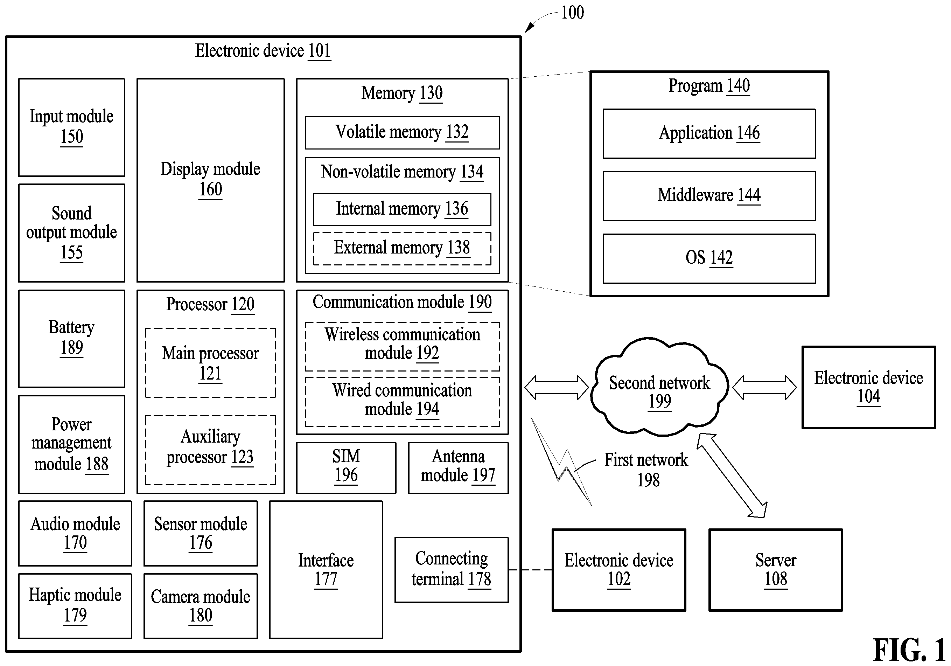

FIG. 1 is a block diagram illustrating an electronic device 101 in a network environment 100 according to an embodiment of the disclosure. Referring to FIG. 1, the electronic device 101 in the network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to one embodiment, the electronic device 101 may communicate with the electronic device 104 via the server 108. According to one embodiment, the electronic device 101 may include a processor 120, a memory 130, an input module 150, a sound output module 155, a display module 160, an audio module 170, and a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added in the electronic device 101. In some embodiments, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 connected to the processor 120, and may perform various data processing or computation. According to one embodiment, as at least a portion of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to one embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is in an active state (e.g., executing an application). According to one embodiment, the auxiliary processor 123 (e.g., an ISP or a CP) may be implemented as a portion of another component (e.g., the camera module 180 or the communication module 190) that is functionally related to the auxiliary processor 123. According to one embodiment, the auxiliary processor 123 (e.g., an NPU) may include a hardware structure specified for artificial intelligence (AI) model processing. An AI model may be generated by machine learning. Such learning may be performed by, for example, the electronic device 101 in which artificial intelligence is performed, or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but is not limited thereto. The AI model may additionally or alternatively include a software structure other than the hardware structure.

The memory 130 may store various data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing record. The receiver may be used to receive an incoming call. According to one embodiment, the receiver may be implemented separately from the speaker or as a part of the speaker.

The display module 160 may visually provide information to the outside (e.g., a user) of the electronic device 101. The display module 160 may include, for example, a control circuit for controlling a display, a hologram device, or a projector and control circuitry to control a corresponding one of the display, the hologram device, and the projector. According to one embodiment, the display module 160 may include a touch sensor adapted to sense a touch, or a pressure sensor adapted to measure an intensity of a force incurred by the touch.

The audio module 170 may convert a sound into an electrical signal or vice versa. According to one embodiment, the audio module 170 may obtain the sound via the input module 150 or output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and generate an electrical signal or data value corresponding to the detected state. According to one embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or an electrical stimulus which may be recognized by a user via his or her tactile sensation or kinesthetic sensation. According to one embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently of the processor 120 (e.g., an AP) and that support a direct (e.g., wired) communication or a wireless communication. According to one embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and a next-generation communication technology, e.g., a new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to one embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to one embodiment, another component (e.g., a radio frequency integrated circuit (RFIC)) other than the radiating element may be additionally formed as a part of the antenna module 197.

According to an embodiment, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of the same type as or a different type from the electronic device 101. According to one embodiment, all or some of operations to be executed by the electronic device 101 may be executed at one or more of the external electronic devices 102, 104, and 108. For example, if the electronic device 101 needs to perform a function or a service automatically, or in response to a request from a user or another device, the electronic device 101, instead of, or in addition to, executing the function or the service, may request one or more external electronic devices to perform at least part of the function or the service. The one or more external electronic devices receiving the request may perform the at least part of the function or the service requested, or an additional function or an additional service related to the request, and may transfer an outcome of the performing to the electronic device 101. The electronic device 101 may provide the result, with or without further processing the result, as at least part of a response to the request. To this end, cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an Internet-of things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., a smart home, a smart city, a smart car, or healthcare) based on 5G communication technology or IoT-related technology.

The electronic device according to embodiments may be one of various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic device is not limited to those described above.

It should be appreciated that embodiments of the disclosure and the terms used therein are not intended to limit the technological features set forth herein to particular embodiments and include various changes, equivalents, or replacements for a corresponding embodiment. In connection with the description of the drawings, like reference numerals may be used for similar or related components. As used herein, "A or B", "at least one of A and B", "at least one of A or B", "A, B or C", "at least one of A, B and C", and "A, B, or C," each of which may include any one of the items listed together in the corresponding one of the phrases, or all possible combinations thereof. Terms such as "first", "second", or "first" or "second" may simply be used to distinguish the component from other components in question, and may refer to components in other aspects (e.g., importance or order) is not limited. It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., by wire), wirelessly, or via a third element.

As used in connection with embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program 140) including one or more of instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments disclosed herein may be included and provided in a computer program product. The computer program product may be traded as a product between a seller and a buyer. The computer program product may be distributed in the form of a machine-readable storage medium (e.g., compact disc read-only memory (CD-ROM)), or be distributed (e.g., downloaded or uploaded) online via an application store (e.g., PlayStoreTM), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to embodiments, each component (e.g., a module or a program) of the above-described components may include a single entity or multiple entities, and some of the multiple entities may be separately disposed in different components. According to embodiments, one or more of the above-described components may be omitted, or one or more other components may be added. Alternatively or additionally, a plurality of components (e.g., modules or programs) may be integrated into a single component. In such a case, according to embodiments, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

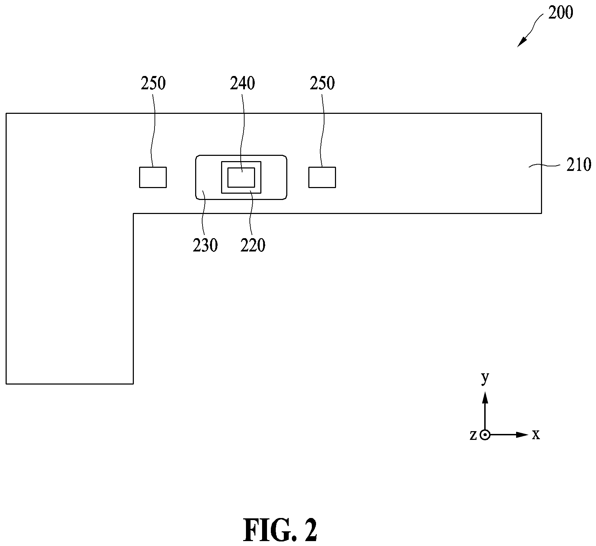

FIG. 2 is a plan view of an electronic device according to an embodiment of the disclosure.

Referring to FIG. 2, an electronic device 200 (e.g., the electronic device 101 of FIG. 1) according to various embodiments may have a slim structure through a bridge PCB that connects different PCBs. The electronic device 200 may include a PCB structure including a plurality of PCBs 210, 220, and 230, an application processor 240 disposed on the PCB structure, and a first component. For example, the first component may be an integrated circuit (IC).

In various embodiments, the plurality of PCBs 210, 220, and 230 may include the first PCB 210, the second PCB 220, and the bridge PCB 230. For example, the second PCB 220 may be a relatively high-performance PCB compared to the first PCB 210. For example, the second PCB 220 may include more layers than the first PCB 210. In addition, the second PCB 220 may include a dielectric having a lower loss rate than the first PCB 210.

In various embodiments, the first PCB 210 may support the first component. The second PCB 220 may support the application processor 240, a second component, and/or a decapsulator. For example, the second component may include a power management integrated circuit (PMIC) and the first component may include various ICs performing different functions other than a power management function.

Hereinafter, in the disclosure, the first component may be referred to as an IC and the second component may be referred to as a PMIC.

In various embodiments, the application processor 240 may include a central processing unit (CPU), a graphics processing unit (GPU), and/or a digital signal processor (DSP). The application processor 240 may interpret a command of a user and may process data. The application processor 240 may process graphics. The application processor 240 may process a task that implements a task computed by the CPU on a screen. The application processor 240 may rapidly process analog data by converting the analog data into a digital signal. The application processor 240 may be disposed on a PCB having relatively high performance. For example, the application processor 240 may be disposed on the second PCB 220.

In various embodiments, the PMIC may include a chip configured to receive main power and convert, rectify, distribute, and/or control the main power into an efficient voltage or current required by the electronic device 200. For example, the PMIC may be disposed on a PCB having relatively high performance and an IC may be disposed on a PCB having relatively low performance. For example, the first PCB 210 may have relatively low performance and the second PCB 220 may have relatively high performance. For example, the PMIC may be disposed on the second PCB 220. Based on the second PCB 220, the application processor 240 and the PMIC may be disposed on opposite sides to each other. For example, the application processor 240 may be disposed on a top surface (e.g., the +z-axis direction) of the second PCB 220 and the PMIC may be disposed on a bottom surface (e.g., the -z-axis direction) of the second PCB 220.

In various embodiments, the first PCB 210 may have a relatively large area. The second PCB 220 may have a relatively small area. The PCB structure may be designed so that the second PCB 220 having the high performance may have a relatively small area.

In various embodiments, the first PCB 210 and the second PCB 220 may be provided substantially in parallel on an xy plane. For example, the first PCB 210 and the second PCB 220 may be spaced apart from each other on the xy plane.

In various embodiments, the bridge PCB 230 may connect the first PCB 210 to the second PCB 220. The bridge PCB 230 may at least partially overlap the first PCB 210 and the second PCB 220 in the z-axis direction. Herein, the +z direction may be referred to as an upper direction and the -z direction may be referred to as a lower direction.

In various embodiments, the bridge PCB 230 may be disposed in the upper or lower direction of the first PCB 210 and the second PCB 220. Hereinafter, the description is provided based on that the bridge PCB 230 is disposed in the upper direction of the first PCB 210 and the second PCB 220. However, the example is not limited thereto. For example, the bridge PCB 230 may be disposed in the lower direction of the first PCB 210 and the second PCB 220.

In various embodiments, an IC 250 may be disposed on the first PCB 210. A plurality of ICs 250 may be provided. Some of the ICs 250 may be disposed on the top surface of the first PCB 210 and the others may be disposed on the bottom surface of the first PCB 210.

In various embodiments, as the IC 250 is disposed on the first PCB 210 instead of the bridge PCB 230, the electronic device 200 may have a slim structure based on the z-axis direction. The bridge PCB 230 may support the first PCB 210 and the second PCB 220 to provide in parallel. For example, the first PCB 210, having a relatively large area, may include a hole to accommodate at least a portion of the second PCB 220 and some components disposed on the second PCB 220 may be inserted into the hole. For example, the first PCB 210 and the second PCB 220 may be provided on substantially the same plane. In the bridge PCB 230, a relatively outer portion of the bridge PCB 230 may at least partially overlap the first PCB 210, and a relatively inner portion of the bridge PCB 230 may at least partially overlap the second PCB 220.

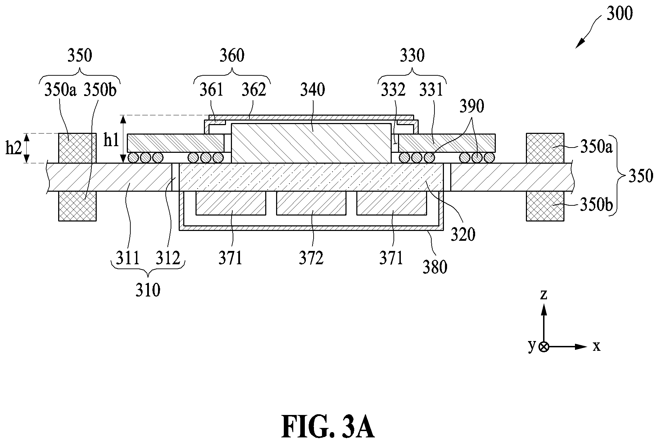

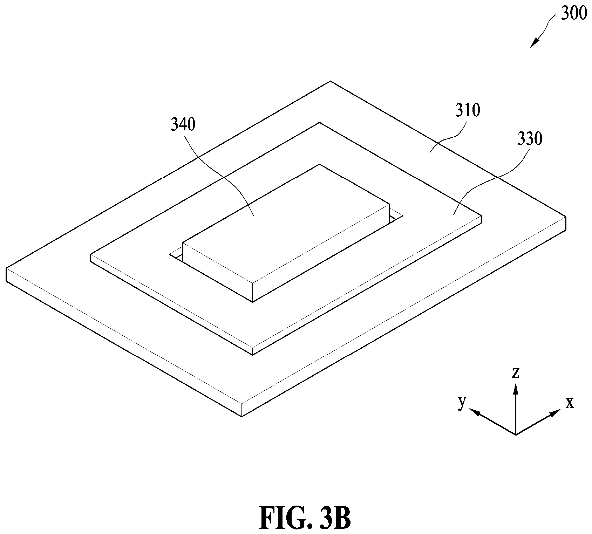

FIG. 3A is a cross-sectional view of an electronic device according to an embodiment of the disclosure and FIG. 3B is a perspective view of an electronic device according to an embodiment of the disclosure. For reference, it shall be noted that FIG. 3B omits an IC 350 and a main shield 360.

Referring to FIGS. 3A and 3B, according to various embodiments, an electronic device 300 (e.g., the electronic device 101 of FIG. 1) may include a PCB structure including a first PCB 310, a second PCB 320, and a bridge PCB 330. The electronic device 300 may include an application processor 340 disposed on the second PCB 320, a plurality of ICs 350 disposed on the first PCB 310, the main shield 360 configured to cover the application processor 340 and block noise, a PMIC 371 and a decapsulator 372 disposed on the second PCB 320, a sub-shield 380 configured to cover the PMIC 371 and the decapsulator 372 and block noise, and a plurality of solder balls 390 configured to electrically connect the first PCB 310 and the second PCB 320 to the bridge PCB 330.

In various embodiments, the first PCB 310 may include a first PCB body 311 including a plurality of layers and a main hole 312 penetrating the first PCB body 311. The main hole 312 may accommodate at least a portion of the second PCB 320.

In various embodiments, the first PCB 310 and the second PCB 320 may be positioned in substantially the same direction relative to the bridge PCB 330. For example, the first PCB 310 and the second PCB 320 may be positioned in the -z direction from the bridge PCB 330.

In various embodiments, the main hole 312 and the second PCB 320 may have various shapes. For example, the main hole 312 and the second PCB 320 may have various shapes, such as a polygon (e.g., a square, a rectangle, a pentagon) or a circle (an oval).

In various embodiments, the bridge PCB 330 may include a bridge PCB body 331 including a plurality of layers and a bridge hole 332 penetrating the bridge PCB body 331. The bridge hole 332 may accommodate at least a portion of the application processor 340. The main hole 312 and the bridge hole 332 may be provided in parallel in the z-axis direction corresponding to a stacking direction of the first PCB 310 and the bridge PCB 330. The size of the bridge hole 332 may be smaller than the size of the hole 312.

In various embodiments, the height of the application processor 340 may be greater than the height of the IC 350.

In various embodiments, the plurality of ICs 350 may include a first IC 350a disposed on the top surface of the first PCB 310 and spaced apart from the bridge PCB 330 in a lateral direction and a second IC 350b disposed on the bottom surface of the first PCB 310. The first IC 350a and the second IC 350b may be provided on opposite sides to each other based on the first PCB 310. The first IC 350a may be spaced apart from the bridge PCB 330 in a stacking direction of the first PCB 310 and the bridge PCB 330, in other words, in a direction intersecting with the z-axis direction.

In various embodiments, the main shield 360 may block an electromagnetic wave radiated from the application processor 340 to the outside or an electromagnetic wave entering the application processor 340 from the outside. The main shield 360 may include a shield leg 361 connected to the bridge PCB 330 and a shield body 362 connected to the shield leg 361 and having a plate shape. The shield leg 361 may separate the shield body 362 upwardly from the top surface of the bridge PCB 330. According to the structure described above, even if a sum of the heights of the bridge PCB 330 and the solder ball 390 is less than the height of the application processor 340, the main shield 30 may cover the application processor 340 while being stably disposed on the bridge PCB 330.

In various embodiments, the PMIC 371 and the decapsulator 372 may be disposed on the bottom surface of the second PCB 320. The PMIC 371 and the decapsulator 372 may be provided on an opposite side to the application processor 340 based on the second PCB 320.

In various embodiments, the sub-shield 380 may be disposed on the second PCB 320, may cover the PMIC 371 and the decapsulator 372, and may block noise. The sub-shield 380 may block an electromagnetic wave radiated from the PMIC 371 and/or the decapsulator 372 to the outside or an electromagnetic wave entering the PMIC 371 and/or the decapsulator 372 from the outside.

In various embodiments, the bridge PCB 330 may assist in determining the total height of the electronic device 300 by the main shield 360 and the sub-shield 380. Due to the bridge PCB 330, the electronic device 300 may have a slim structure. A first length h1 corresponding to a maximum distance from one surface of the first PCB 310 to one surface of the main shield 360 may be greater than a second length h2 corresponding to the height of the first IC 350a. According to the structure described above, the top surface of the first IC 350a may be provided at a lower position than the top surface of the main shield 360. The standard for determining the total height of the electronic device 300 may be the main shield 360 instead of the first IC 350a disposed on the first PCB 310. For example, the height of the application processor 340 may be greater than the height of the first IC 350a.

In various embodiments, the bridge PCB 330 may assist in determining the total height of the electronic device 300 by the main shield 360 and the sub-shield 380. Due to the bridge PCB 330, the electronic device 300 may have a slim structure. The maximum distance from the other surface of the first PCB 310 to one surface of the sub-shield 380 may be greater than the height of the second IC 350b. According to the structure described above, the top surface of the second IC 350b may be provided at a lower position than the top surface of the sub-shield 380. The standard for determining the total height of the electronic device 300 may be the sub-shield 380 instead of the second IC 350b disposed on the first PCB 310. According to the structure described above, the total thickness of the electronic device 300 may be determined by the main shield 360 and the sub-shield 380 and may be relatively slim compared to a state without the bridge PCB 330. For example, unlike the electronic device 300 shown in FIG. 3A, in a structure in which the first PCB is directly connected to the second PCB, the thickness of the electronic device may be determined by the first IC 350a and the sub-shield 380. The thickness of the electronic device may be, for example, 3.1 mm. In addition, the thickness of the electronic device 300 including the bridge PCB 330 may be determined by the main shield 360 and the sub-shield 380 and may be, for example, 2.8 mm. For example, the electronic device 300 may reduce the thickness by approximately 0.3 mm through the bridge PCB 330.

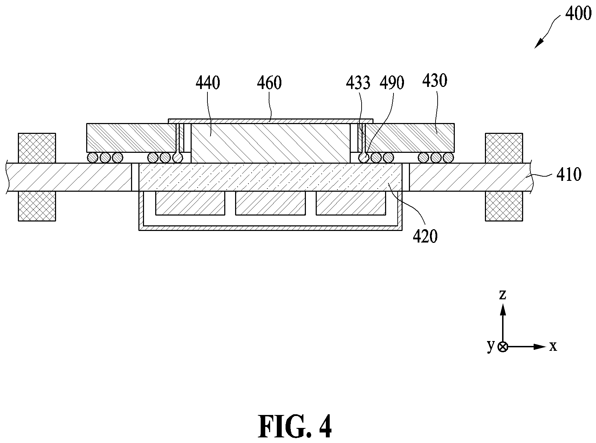

FIG. 4 is a cross-sectional view of an electronic device according to an embodiment of the disclosure.

Referring to FIG. 4, an electronic device 400 (e.g., the electronic device 101 of FIG. 1) according to various embodiments may include a first PCB 410, a second PCB 420, a bridge PCB 430, a ground via 433, an application processor 440, a main shield 460, and a plurality of solder balls 490.

In various embodiments, some of the plurality of solder balls 490 may connect the first PCB 410 to the bridge PCB 430 and the others may connect the second PCB 420 to the bridge PCB 430.

In various embodiments, the ground via 433 may be provided on the bridge PCB 430. An end of the ground via 433 may be connected to one of the plurality of solder balls 490 and the other end may be connected to the main shield 460.

In various embodiments, a sum of the heights of the bridge PCB 430 and the solder ball 490 may be equal to or greater than the height of the application processor 440. For example, a worker may select the bridge PCB 430 having the appropriate thickness and may set a sum of the heights of the bridge PCB 430 and the solder ball 490 to be equal to or greater than the height of the application processor 440. The thickness of the bridge PCB 430 may be determined by the number of layers configuring the bridge PCB and/or the thickness of a dummy layer provided inside the bridge PCB. According to the structure described above, the main shield 460 may have a plate shape without a separate shield leg (e.g., the shield leg 361 of FIG. 3A). For example, the main shield 460 may include shield tapes respectively attached to the bridge PCB 430 and the application processor 440.

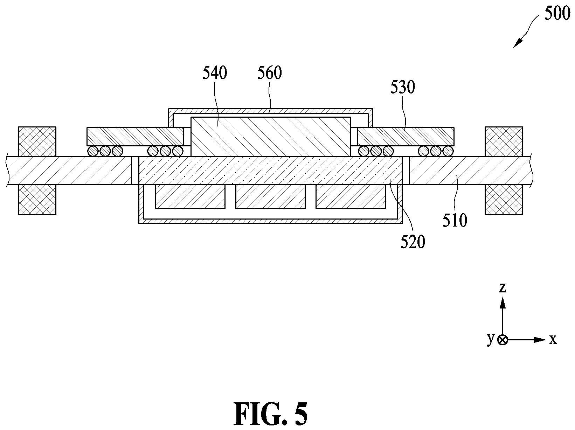

FIG. 5 is a cross-sectional view of an electronic device according to an embodiment of the disclosure.

Referring to FIG. 5, an electronic device 500 (e.g., the electronic device 101 of FIG. 1) according to various embodiments may include a first PCB 510, a second PCB 520, a bridge PCB 530, an application processor 540, and a main shield 560.

In various embodiments, the main shield 560 may include a shield leg (e.g., the shield leg 361 of FIG. 3A) and a shield body (e.g., the shield body 362 of FIG. 3A). The shield leg and the shield body may be integrally formed as one. For example, the main shield 560 may have a shield can shape.

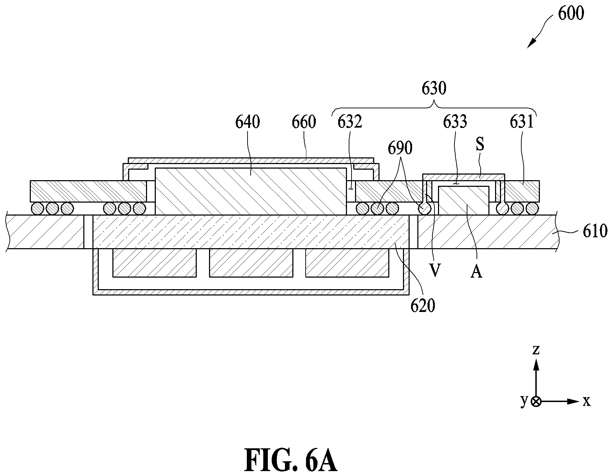

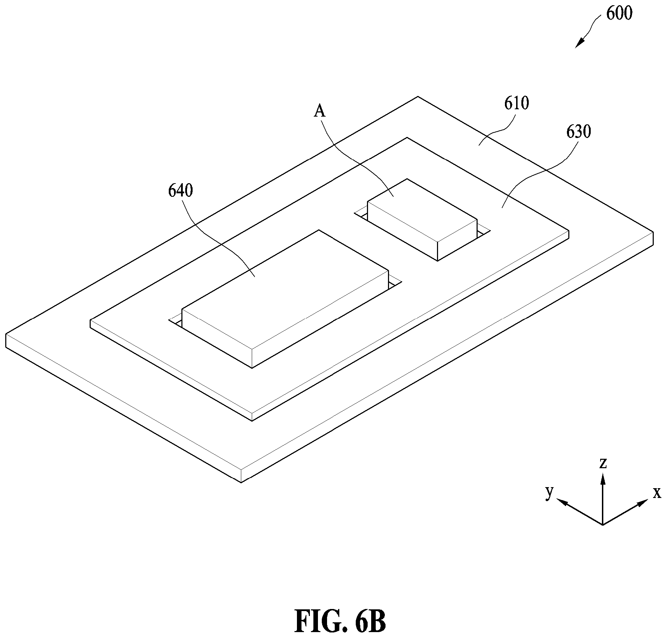

FIG. 6A is a cross-sectional view of an electronic device according to an embodiment of the disclosure and FIG. 6B is a perspective view of an electronic device according to an embodiment of the disclosure. It shall be noted that FIG. 6B omits a main shield 660 and an antenna shield S.

Referring to FIGS. 6A and 6B, an electronic device 600 (e.g., the electronic device 101 of FIG. 1) according to various embodiments may include a first PCB 610, a second PCB 620, a bridge PCB 630, an application processor 640, a main shield 660, an antenna module A (e.g., the antenna module 197 of FIG. a), a ground via V (e.g., the ground via 433 of FIG. 4), and an antenna shield S.

In various embodiments, the bridge PCB 630 may include a bridge PCB body 631, a bridge hole 632 penetrating the bridge PCB body 631, and an antenna hole 633.

In various embodiments, the antenna hole 633 may accommodate at least a portion of the antenna module A. The antenna hole 633 may overlap the first PCB 610 in a stacking direction of the first PCB 610 and the bridge PCB 630. The antenna hole 633 may be spaced apart from the bridge hole 632 on the xy plane.

In various embodiments, the antenna module A (e.g., the antenna module 197 of FIG. 1) may be disposed on the first PCB 610 and may be at least partially inserted into the antenna hole 633.

In various embodiments, some of the plurality of solder balls 690 may connect the first PCB 610 to the bridge PCB 630 and the others may connect the second PCB 620 to the bridge PCB 630.

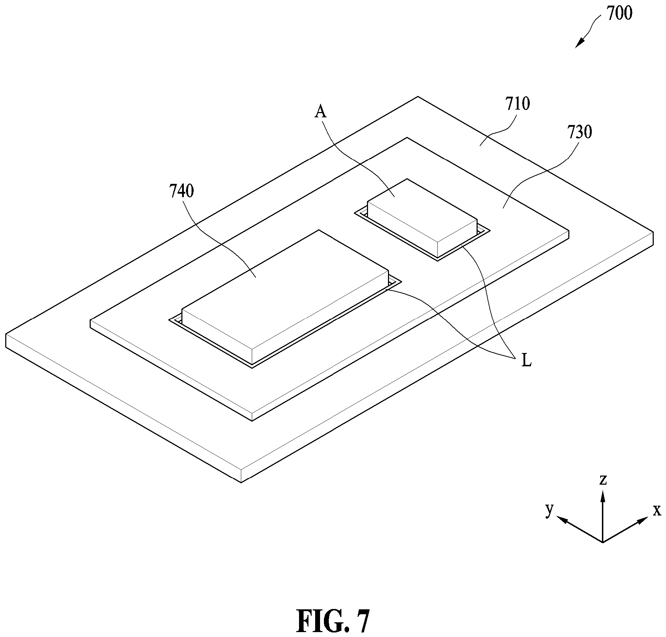

In various embodiments, it shall be noted that the main shield 660 and the antenna shield S may have the shape and/or structure of the shield applied to the embodiments described with reference to FIGS. 3A, 3B, 4, and 5. FIG. 7 is a perspective view of an electronic device according to an embodiment of the disclosure.

An electronic device 700 according to various embodiments of FIG. 7 may include a first PCB 710, a second PCB (e.g., the second PCB 620 of FIG. 6A), a bridge PCB 730, an application processor 740, an antenna module A, and a plated layer L.

In various embodiments, the plated layer L may be disposed in an inner wall of the bridge PCB 730 facing the application processor 740 or the antenna module A. The plated layer L may improve a noise blocking effect of the application processor 740 and the antenna module A. In various embodiments, the electronic device 700 may be manufactured through a manufacturing process shown below.

Firstly, the application processor 740 may be disposed on the second PCB. The bridge PCB 730 may be connected to the second PCB. The plated layer L may be provided on the inner wall of the bridge PCB 730. The second PCB and the bridge PCB 730 may be prepared together in a module type.

Thereafter, a main hole to accommodate the second PCB in the first PCB 710 may be cut. The positions of the first PCB 710 and the second PCB may be adjusted to position the main hole and the second PCB substantially in parallel with each other.

Lastly, the bridge PCB 730 may be connected to the first PCB 710.

According to various embodiments, the electronic device 300 may include the first PCB 310 including a main hole, the second PCB 320 inserted into the main hole and enclosed by the first PCB, the bridge PCB 330, which is configured to connect the first PCB and the second PCB, overlaps the first PCB and the second PCB, and includes a bridge hole, the application processor 340 disposed on the second PCB, inserted into the bridge hole, and enclosed by the bridge PCB, and the main shield 360 connected to the bridge PCB and configured to cover the application processor.

In various embodiments, the first PCB 310 and the second PCB 320 may be positioned in the same direction based on the bridge PCB.

In various embodiments, the electronic device may further include the first component disposed on the first PCB and spaced apart from the bridge PCB in a direction intersecting with a stacking direction of the first PCB and the bridge PCB.

In various embodiments, the first length h1, which corresponds to a maximum distance from one surface of the first PCB to one surface of the main shield, may be greater than the second length h2, which corresponds to the height of the first component.

In various embodiments, the height of the application processor 340 may be greater than the height of the first component.

In various embodiments, the main hole 312 and the bridge hole 332 may be provided in parallel with each other in the stacking direction of the first PCB and the bridge PCB.

In various embodiments, the size of the bridge hole 332 may be less than the size of the main hole 312.

In various embodiments, the main shield 360 may include the shield leg 361 connected to the bridge PCB, and the shield body 362 connected to the shield leg and having a plate shape.

In various embodiments, the electronic device may further include the plurality of solder balls 490 configured to connect the second PCB to the bridge PCB, and the ground via 433 provided on the bridge PCB and configured to connect one of the plurality of solder balls to the main shield.

In various embodiments, a sum of heights of the bridge PCB and one of the plurality of solder balls 390 may be equal to or greater than the height of the application processor.

In various embodiments, the main shield 460 may include shield tapes respectively attached to the bridge PCB and the application processor.

In various embodiments, the electronic device may further include the first component disposed on the first PCB and spaced apart from the bridge PCB in a direction intersecting with the stacking direction of the first PCB and the bridge PCB, the second component disposed on the second PCB and provided at an opposite side to the application processor based on the second PCB, and the sub-shield 380 configured to cover the second component.

In various embodiments, the bridge PCB 630 may further include the antenna hole 633 that overlaps the first PCB based on the stacking direction of the first PCB and the bridge PCB.

In various embodiments, the electronic device may further include the antenna module A disposed on the first PCB and inserted into the antenna hole, and the antenna shield S connected to the bridge PCB and configured to cover an antenna.

In various embodiments, the bridge PCB may further include the plated layer L disposed on the inner wall facing the application processor.

In various embodiments, the electronic device 300 may include the first PCB 310 including a main hole, the second PCB 320 inserted into the main hole and enclosed by the first PCB, and the bridge PCB 330, which is configured to connect the first PCB and the second PCB, overlaps the first PCB and the second PCB, and includes a bridge hole.

In various embodiments, the first PCB 310 and the second PCB 320 may be positioned in the same direction based on the bridge PCB.

In various embodiments, the electronic device may further include the main shield connected to the bridge PCB, and the first component disposed on the first PCB and spaced apart from the bridge PCB in a direction intersecting with a stacking direction of the first PCB and the bridge PCB, wherein a maximum distance from one surface of the first PCB to one surface of the main shield may be greater than a height of the first component.

In various embodiments, the size of the bridge hole 332 may be less than the size of the main hole 312.

According to various embodiments, the electronic device 300 may include the first PCB 310 including a main hole, the second PCB 320 inserted into the main hole and enclosed by the first PCB, the bridge PCB 330, which is configured to connect the first PCB and the second PCB, overlaps the first PCB and the second PCB, and includes a bridge hole, the application processor 340 disposed on the second PCB, inserted into the bridge hole, and enclosed by the bridge PCB, the main shield 360 connected to the bridge PCB and configured to cover the application processor, and the first component disposed on the first PCB and spaced apart from the bridge PCB in a direction intersecting with the stacking direction of the first PCB and the bridge PCB, wherein the maximum distance from one surface of the first PCB to one surface of the main shield may be greater than a height of the first component, and the main hole and the bridge hole may be provided in parallel with each other in the stacking direction of the first PCB and the bridge PCB.

While the disclosure has been shown and described with reference to various embodiments thereof, it will be understood by those skilled in the art that various changes in form and details may be made therein without departing from the spirit and scope of the disclosure as defined by the appended claims and their equivalents.

## Claims

1. An electronic device comprising:
a first printed circuit board (PCB) comprising a main hole;
a second PCB inserted into the main hole and enclosed by the first PCB;
a bridge PCB configured to connect the first PCB and the second PCB and disposed so as to overlap the first PCB and the second PCB, the bridge PCB including a bridge hole;
an application processor disposed on the second PCB, inserted into the bridge hole, and enclosed by the bridge PCB; and
a main shield connected to the bridge PCB and configured to cover the application processor.

2. The electronic device of claim 1, wherein the first PCB and the second PCB are positioned in a same direction based on the bridge PCB.

3. The electronic device of claim 2, further comprising:
a first component disposed on the first PCB and spaced apart from the bridge PCB in a direction intersecting with a stacking direction of the first PCB and the bridge PCB.

4. The electronic device of claim 3, wherein a maximum distance from one surface of the first PCB to one surface of the main shield is greater than a height of the first component.

5. The electronic device of claim 3, wherein a height of the application processor is greater than a height of the first component.

6. The electronic device of claim 1, wherein the main hole and the bridge hole are provided in parallel with each other in a stacking direction of the first PCB and the bridge PCB.

7. The electronic device of claim 1, wherein a size of the bridge hole is less than a size of the main hole.

8. The electronic device of claim 1, wherein the main shield comprises:
a shield leg connected to the bridge PCB; and
a shield body connected to the shield leg and having a plate shape.

9. The electronic device of claim 1, further comprising:
a plurality of solder balls configured to connect the second PCB to the bridge PCB; and
a ground via provided on the bridge PCB and configured to connect one of the plurality of solder balls to the main shield.

10. The electronic device of claim 9, wherein a sum of heights of the bridge PCB and one of the plurality of solder balls is equal to or greater than a height of the application processor.

11. The electronic device of claim 10, wherein the main shield comprises shield tapes respectively attached to the bridge PCB and the application processor.

12. The electronic device of claim 1, further comprising:
a first component disposed on the first PCB and spaced apart from the bridge PCB in a direction intersecting with a stacking direction of the first PCB and the bridge PCB;
a second component disposed on the second PCB and provided at an opposite side to the application processor based on the second PCB; and
a sub-shield configured to cover the second component.

13. The electronic device of claim 1, wherein the bridge PCB further comprises an antenna hole that overlaps the first PCB based on a stacking direction of the first PCB and the bridge PCB.

14. The electronic device of claim 13, further comprising:
an antenna module disposed on the first PCB and inserted into the antenna hole; and
an antenna shield connected to the bridge PCB and configured to cover an antenna.

15. The electronic device of claim 1, wherein the bridge PCB further comprises a plated layer disposed on an inner wall facing the application processor.
